# EUROPEAN PATENT APPLICATION

(11) **EP 3 166 141 A1**
(43) Date of publication of application: **10.05.2017**
(21) Application number: 16196081.0
(22) Date of filing: 27.10.2016
(51) Int. Cl.: H01L 23/34, G01K 1/14, G01K 1/16, G01K 13/00, H01L 25/16

(54) **ELECTRONIC DEVICE WITH ELECTRONIC POWER COMPONENT AND DIRECT DETECTION OF THE TEMPERATURE OF SUCH A COMPONENT**

(30) Priority: 04.11.2015 IT UB20155239
(71) Applicant: Magneti Marelli S.p.A., 20011 Corbetta (MI) (IT)
(72) Inventor: TIZIANI, Roberto, I-20014 Nerviano, Milano (IT); SOGLIO, Fabrizio, I-20900 Monza, Monza E Della Brianza (IT); GIULIANI, Giovanni Franco, I-20081 Abbiategrasso, Milano (IT)
(74) Representative: Brunazzi, Stefano

(57) **Abstract**

It is described an electronic device 1 comprising a temperature detection component 2 and an integrated electronic power component 3, the device being adapted to be mounted on the substrate S.

The electronic integrated power component 3 has a first surface portion 31, adapted to be mounted on the substrate S, and a second surface portion 32, opposite to the first surface portion.

The temperature detection component 2 comprises two sensor terminals 21, 22, adapted to be connected to the substrate S by means of wire bonding W, and further comprises a temperature sensor 20, configured to detect a temperature T representative of the temperature T3 of the integrated electronic power component 3 and to provide, by means of the two sensor terminals 21, 22, an electrical signal V representative of the detected temperature T.

The temperature detection component 2 further comprises an electrically insulating support 23, having a gluing surface 24 glued on said second surface portion 32 of the integrated electronic power component 3.

The temperature sensor 20 and the sensor terminals 21, 22 are arranged in a planar configuration on a surface 25 of the support 23 opposite to the gluing surface 24, so that the temperature detection component 2 is superimposed on the integrated electronic power component 3 and so that the temperature sensor 20 and the two sensor terminals 21, 22 are electrically insulated with respect to the integrated electronic power component 3.

## Description

### TECHNOLOGICAL BACKGROUND OF THE INVENTION

### Field of application.

The present invention relates to the technical field of electronic power devices.

In particular, the invention relates to an electronic device provided with an integrated electronic power component and capable of carrying out a direct, accurate detection of the temperature of such a component.

Furthermore, the invention relates to a method employing such a device for measuring the operating temperature of an integrated electronic power component of the device itself.

The invention further relates to an electronic module and an electronic system comprising the aforesaid device, adapted to manage energy flows, in particular (although not restrictively) in the field of motion systems and batteries for electrical or hybrid traction motor vehicles.

### Description of the prior art.

The electronic power modules/devices that control the flow of energy between battery and motor/inverter assembly play a key role in the automotive field, particularly in the aforesaid context of motion systems and batteries for electric or hybrid traction motor vehicles. Such electronic modules/devices are configured to operate at various voltage and power levels, both at "high voltage" (e.g., 380 or 450 V) and "high power" (e.g., 50 kW), and at voltage (e.g., 48 V or 60 V) and power (e.g., 10 kW) which are defined "low" in this context, but are still quite high. The high power in play determines the need to arrange and control appropriate dissipation mechanisms (e.g., with water cooling) and to monitor the temperatures reached by the electronic components.

More specifically, in such a context, controlling the temperature of the electronic power components is very important both in order to avoid overheating caused by anomalies (and thus implementing protection or safety procedures), and to obtain indications on current flows (and thus implementing procedures of controlled limitation of such currents where needed). With reference to the latter aspect, it is worth noting that, even in certain normal operating conditions of electric or hybrid motors, the currents, if not limited, could reach very high, unacceptable values: such situations occur, for example, when an electric motor is in "0 RPM" condition upon starting from a standstill or uphill.

The control strategies normally used include estimating the temperature present at the electronic power modules/components and carrying out current limitations, i.e., power reductions or derating, when the temperature exceeds a predetermined threshold.

From here the need arises to estimate the temperature in an accurate manner and to track the variations thereof as rapidly as possible.

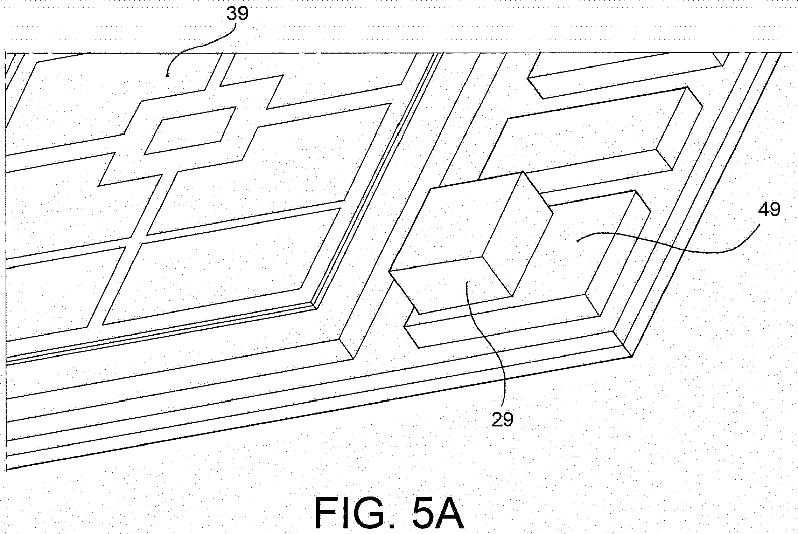

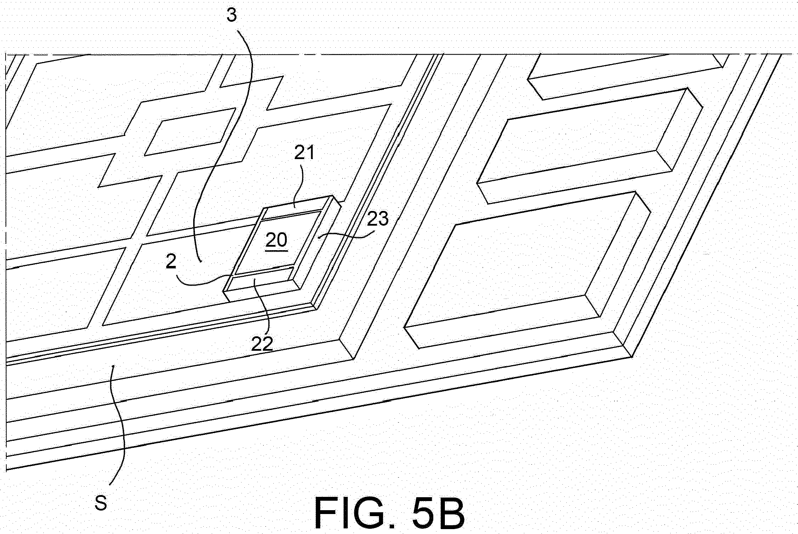

In the known systems and methods (a simplified illustration of which is shown in figure 5A) belonging to the technical context indicated above, the temperature estimate is based on temperature measurements made at the "electronic module" level: for example, by means of a thermistor 29, distinct from the electronic power component 39 the temperature of which is intended to be estimated, typically mounted on the same ceramic substrate, i.e., on the ceramic substrate of the "electronic module" which contains both the power component 39 and the thermistor 29.

The thermistors that are typically used in this context are "vertical"-structure thermistors 29, i.e., having a heat sensitive element, two electrodes and respective terminals arranged on the lower and upper surfaces of the sensitive element (wherein the words "upper" and "lower" refer to the assembly orientation of the thermistor). So, when the thermistor 29 is installed, one of the terminals of the thermistor is in contact with the substrate of the module, e.g., a ceramic substrate at a dedicated pad 49 obtained on the substrate.

In such a case, the need to maintain the thermistor in electric insulation conditions with respect to the electronic power device compels to mount the thermistor on a relatively distant pad (for example, the minimum distance between the copper pads is 0.5 mm to comply with the electric insulation) with respect to the component the temperature of which is intended to be measured.

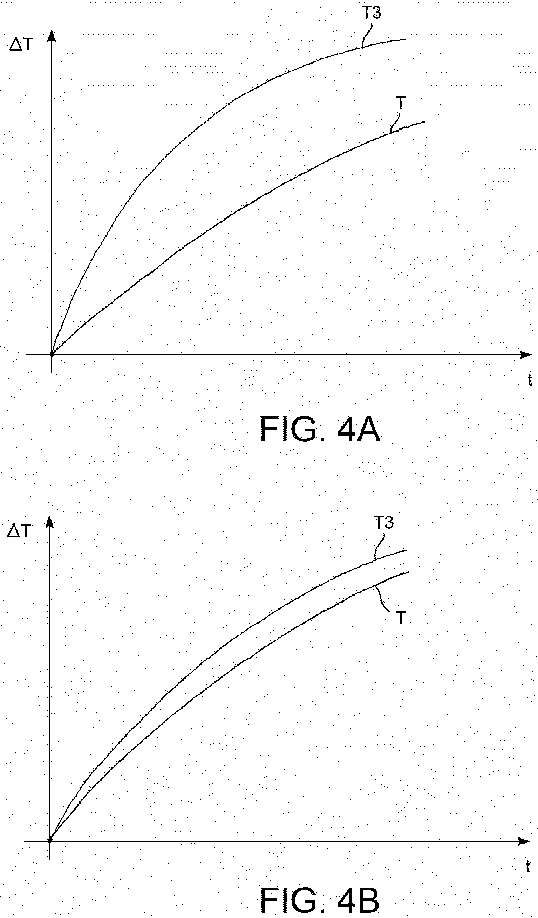

This implies the obvious disadvantage that the temperature measured by the thermistor may be considerably different from the real temperature of the power device: just to give an example, a heat excursion in the order of 70°C in the electronic power component is typically found to correspond to a heat excursion in the order of 15°C in the thermistor. The power component temperature is thus estimated on the basis of a calibration factor, defined on the basis of time evolution curves of the detected temperature T and of the actual temperature of the component, measured separately, which are initially determined in a step of characterization of the module (see for example the diagram in figure 4A). Such a calibration factor may be stored and then used in a processor capable of performing the calculations necessary for the estimation.

The known solution illustrated above may imply drawbacks related to low temperature estimation accuracy and/or of performance decay, over time, during the operating life of the module.

Even more serious are the drawbacks related to the dynamic behavior of the thermistor. Because of thermal inertia, and given the distance between the thermistor and the electronic power component, the detection of a rapid current peak, and thus a temperature peak in the component, may be delayed or may go undetected at all, if it has a very short duration. Such a drawback may radically damage the correct operation of the entire current control and/or protection and safety procedure.

Given the aforesaid drawbacks of the known systems and methods, in principle a solution could be to integrate, in manner known in itself, a temperature sensor in the same integrated circuit or chip as the electronic power device: for example, by integrating a silicon diode, operating as temperature sensor. However, such a solution is disadvantageous, or even entirely unfeasible in some contexts, including the one considered here, for reasons of excessive cost and excessive space occupied in the silicon substrate of the chip. Indeed, since the temperature sensor must be electrically insulated with respect to the power circuit, as observed above, a sufficient space of "unused" silicon substrate must be provided around the temperature sensor for the sole purpose of guaranteeing the electric insulation thereof.

In summary, at the moment, the available or conceivable prior art solutions cannot adequately meet the requirements of accuracy, rapidity and fidelity of the electronic power device/component temperature estimate, and moreover have all the aforesaid disadvantages.

In light of the above, mainly in the context of automotive applications, but also in other application contexts, the need is strongly felt to have an electronic device which is provided with an integrated electronic power component and which is also capable of carrying out a direct and accurate detection of the temperature of such a component, and which at the same time does not provide an integration of the temperature sensor in the same chip as the electronic power component.

### SUMMARY OF THE INVENTION

It is the object of the present invention to provide an electronic device provided with an integrated electronic power component and capable of directly and accurately carrying out a detection of the temperature of such a component, the device being such that it can be used, for example, in a motion system for an electrical or hybrid traction vehicle, and such as to allow to at least partially solve the drawbacks indicated above with reference to the prior art and to meet the aforesaid needs which are particularly felt in the technical sector considered.

It is a further object of the present invention an electronic module and an electronic system comprising the aforesaid device, adapted to manage energy flows, for example in the field of motion systems and batteries for electrical or hybrid traction motor vehicles.

A further object of the present invention is a method for measuring an operating temperature of an integrated electronic power component of the device itself.

Such an object is achieved by an electronic device according to claim 1.

Further embodiments of the device are defined in claims 2-8.

A module according to the invention is defined in claim 9.

Further embodiments of the module are defined in claims 10-11.

A system according to the invention is defined in claim 12.

A further embodiment of such a system is defined in claim 13.

A method according to the invention is defined in claim 14.

A further embodiment of such a system is defined in claim 15.

### BRIEF DESCRIPTION OF THE DRAWINGS

Further features and advantages of the electronic device, module and system according to the invention will be apparent from the following description which illustrates preferred embodiments, given by way of indicative, non-limiting examples, with reference to the accompanying figures, in which:
- figure 1 shows a schematic view of a side section of an electronic device according to an embodiment of the present invention;
- figure 2 shows a schematic top plan view of the device in figure 1;
- figure 3 schematically shows a system according to an embodiment of the invention, comprising three modules according to the invention, each of which comprises, in turn, a device such as the one shown in figures 1 and 2;
- figure 4A shows typical time trends of the estimated temperature and of the actual temperature in devices of the prior art;
- figure 4B is a diagram which shows a time trend of the estimated temperature and of the actual temperature in a device according to the present invention;
- figure 5A shows a partial perspective view of a layout of a module comprising a device of the prior art;
- figure 5B shows a partial perspective view of a layout of a module comprising the device according to an embodiment of the invention.

It is worth noting that equal or similar elements in the aforesaid figures will be indicated with the same numeric or alphanumeric references.

### DETAILED DESCRIPTION

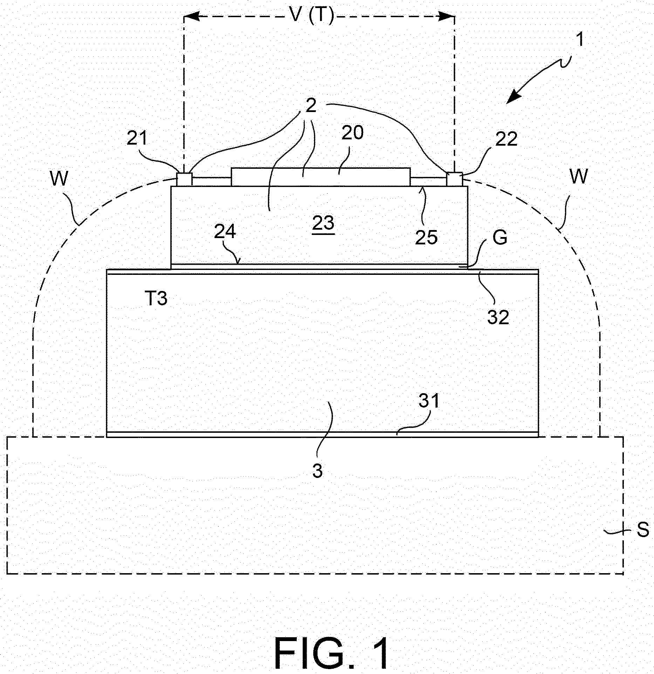

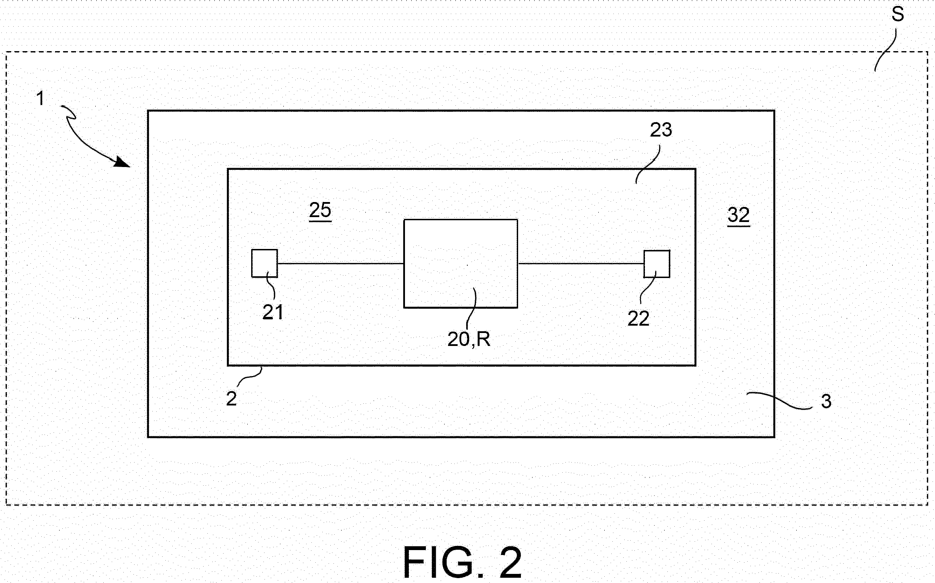

An electronic device 1 will now be described with reference to figures 1 and 2, the device comprising a temperature detection component 2 and an integrated electronic power component 3. The electronic device 1 is adapted to be mounted on a substrate S.

The electronic integrated power component 3 has a first surface portion 31, adapted to be mounted on the substrate S, and a second surface portion 32, opposite to the first surface portion 31.

A temperature detection component 2 comprises two sensor terminals 21, 22, adapted to be connected by wire bonding W to the substrate S, and further comprises a temperature sensor 20. The temperature sensor 20 is configured to detect a temperature T, representative of the temperature T3 of the integrated electronic power component 3, and to provide an electrical signal V, representative of the temperature detected T, by means of the two sensor terminals 21, 22.

The temperature detection component 2 further comprises an electrically insulating support 23, having a gluing surface 24 glued on said second surface portion 32 of the integrated electronic power component 3.

The temperature sensor 20 and the sensor terminals 21, 22 are arranged in a planar configuration on a surface 25 of the support 23 opposite to the gluing surface 24, so that the temperature detection component 2 is superimposed on the integrated electronic power component 3 and so that the temperature sensor 20 and the two sensor terminals 21, 22 are electrically insulated with respect to the integrated electronic power component 3.

It is worth noting that the planar configuration of the temperature detection component 2 implies *inter alia* that the two sensor terminals are both placed on a same plane over the support 23, and on the same plane as the sensor 20, so that all the conductive elements of the temperature detection component 2 are electrically insulated with respect to the electronic power component 3. On the contrary, as previously illustrated, the "vertical"-structure thermistors 29, commonly used in the prior art, require that one of the electrodes and the lower terminal are in contact with the substrate.

For this reason, such "vertical" thermistors cannot be mounted over the electronic power component, whereas the temperature detection component 2 of the present device may be attached directly over the electronic power component 3, while at the same time maintaining the necessary electric insulation requirement between the aforesaid two components.

In this respect, it is also worth noting that in the device 1, described above, there is no contact between the respective conductive portions of the temperature detection component 2 and of the electronic power component 3, and neither are there signal connections for exchanging data between the aforesaid two components.

According to an implementation option, the support 23 is electrically insulating but has high thermal conductivity (i.e., a high capability of transmitting heat by conduction).

According to an implementation example, the electrically insulating support 23 is very thin (e.g., comprised between 200 and 500 µm), which implies that the temperature T at the temperature sensor 20 is either very similar to or even substantially coinciding with the actual temperature at the second surface 32 (upper surface) of the electronic power component 3, and thus with the temperature T3 of such a power component 3.

An example of time evolution of the estimated temperature (T3) and of the actual temperature (T) of the electronic power component 3, in a device according to the present invention, is shown in figure 4B.

In fact, the heat transmission due to a conduction effect from the upper surface 32 of the electronic power component 3 to the temperature sensor 20 is facilitated by the high heat conductivity of the support 23, which is electrically insulating but has a high capability of heat transmission by thermal conduction from the electronic power component 3. The temperature differences between the electronic power component 3 and the temperature sensor 20 are minimized because the dissipated heat is removed through the ceramic substrate S (which is typically in contact with a refrigerating fluid or with an external heat sink). The soldering of the temperature sensor 20 immediately over the dissipating areas of the electronic power component 3 puts such a sensor 20 in substantially isothermal conditions with regard to the electronic power component 3.

According to an embodiment of the device 1, the temperature detection component 2 comprises a planar thermistor 2 made by means of a first chip. The integrated electronic power component 3 is made by means of a second chip, wherein the aforesaid second surface portion 32 is an electrically conductive portion.

The temperature detection component 2 is glued on the integrated electronic power component 3 by means of electrically non-conductive glue G.

In such a case, the aforesaid first and second chips are arranged on top of each other in a "chip-on-chip" configuration.

According to an implementation option, the integrated electronic power component 3 comprises at least one active element belonging to the set comprising: power insulated gate bipolar transistor (IGBT) and/or diode and/or power MOS field-effect transistor (MOSFET).

According to various implementation variants, the most diverse combinations of the aforesaid active elements may be integrated in the chip which constitutes the electronic power component 3.

Such a component may comprise a plurality of integrated active elements, e.g., at least one MOSFET transistor and at least one diode.

According to other implementation variants, the active elements, e.g., one or more power insulated gate bipolar transistors (IGBT) and one or more diodes, may be manufactured separately.

According to an implementation option, the electrically insulating support 23 comprises a layer of insulating ceramic.

According to an alternative option, the electrically insulating support 23 comprises a layer of oxidized silicon.

According to an embodiment of the device 1, the temperature sensor 2 comprises a resistor element R having a resistance R variable in a known manner depending on the temperature. With this regard, it is possible to use temperature sensors *per se* known, e.g., of the NTC (Negative Temperature Coefficient) or PTC (Positive Temperature Coefficient) type.

According to an implementation variant, the temperature sensor 2 is made by means of planar thin film technology. Several layers of metallic materials, performing the function of resistors and having a resistance variable with temperature, are deposited by silk-screen printing on an alumina (aluminum oxide) base. Two pads dedicated to the interconnection with the mother substrate, which accommodates the power elements, are arranged at the terminals of the silk-screen printed resistor.

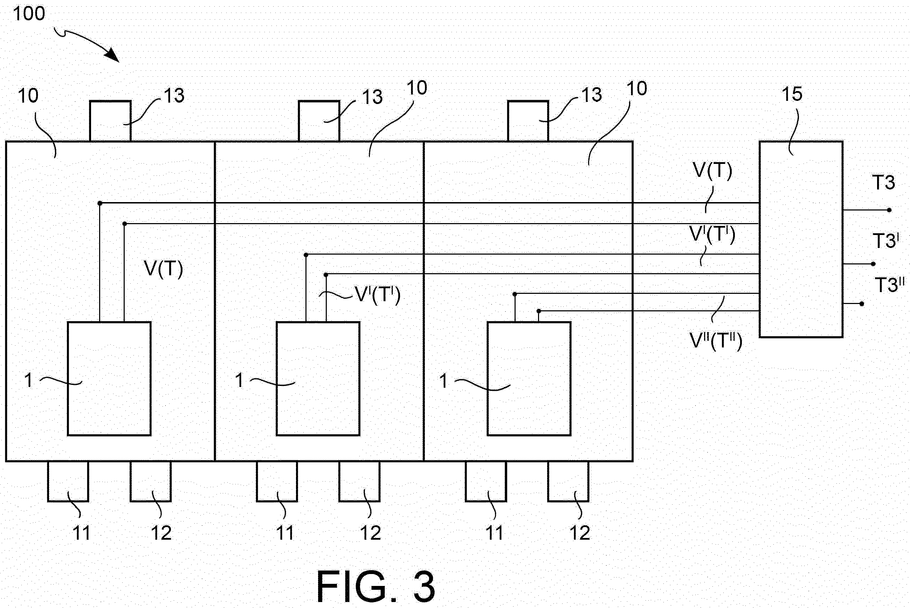

An embodiment of an electronic module 10, according to the present invention, will now be described with reference to figure 3.

The electronic module 10 comprises a ceramic substrate S, on which an electronic device 1 according to any one of the embodiments described above is mounted. The module 10 further comprises two electrical terminals 11, 12 for direct current and a further electrical terminal 13 for alternating current.

According to an implementation option, the two sensor terminals 21, 22 of the electronic device 1 are connected by means of wire bonding W to the substrate S.

According to an implementation option, the module 10 is configured to be connected by means of the two electrical terminals for direct current 11, 12 at voltages either equal to or higher than 380 V, and to operate on electricity flows having power either equal to or greater than 50 kW.

According to an another implementation option, the module 10 is configured to be connected by means of the two electrical terminals for direct current 11, 12 at voltages comprised between 48 V and 60 V, and to operate on electricity flows having power from 10 kW to 20 kW.

Again with reference to figure 3, a system 100, according to the invention, is now described. The system 100 comprises three electronic modules 10, which are mutually similar in structure and operation, according to any one of the embodiments described above.

Such a system 100 further comprises control means 15, configured to receive, from one or more of the temperature detection components 2, one or more respective electrical signals V, V', V" representative of the detected temperatures (T, T', T", respectively), to estimate the temperatures T3, T3', T3" of the integrated electronic power components 3, based on the aforesaid one or more electrical signals V, V', V", and to regulate the operation of the system 100 on the basis of the estimated temperatures T3, T3', T3".

The system 100 is adapted to manage three-phase voltages/currents.

According to an implementation option, the aforesaid control means 15 comprise a control processor 15, configured to carry out safety procedures, reducing or eliminating the electricity flows at predefined risk conditions associated with exceeding one or more predefined temperature thresholds.

The electronic module 10 and the system 100 described above are typically applied in the automotive context and can be used, for example, to connect/disconnect in controllable manner a battery and a motor/inverter group in a motion assembly for electric or hybrid traction vehicles. The electronic module 10 and the system 100, by virtue of the electronic devices 1 comprised therein, can accurately detect the temperature of the electronic power components and carry out appropriate monitoring, control and protection procedures.

In such a context, as previously indicated, the module 10 and the system 100 can be configured to operate in the typical conditions which may be expected, i.e., at "high voltage" (e.g., 380 or 450 V) and "high power" (e.g., 50 kW), or at lower voltage (e.g., 48 V or 60 V) and lower power (e.g., 10 kW).

A method for measuring an operating temperature of an integrated electronic power component 3 having a first surface portion 31, adapted to be mounted on a substrate S, and a second surface portion 32, opposite to the first surface portion 31, is described below.

The method firstly provides the step of gluing on said second surface portion 32 of the integrated electronic power component 3 a temperature detection component 2, having planar configuration and comprising two sensor terminals 21, 22, a temperature sensor 20 and an electrically insulating support 23, so that the temperature detection component 2 is superimposed on the integrated electronic power component 3 and the temperature sensor 20 and the two sensor terminals 21, 22 are electrically insulated from the integrated electronic power component 3.

The method then provides the steps of detecting, by means of the temperature sensor 20, a temperature T present at the sensor 20 and representative of the temperature T3 of the integrated electronic power component 3; then, supplying, by means of the two sensor terminals 21, 22, an electrical signal V representative of the detected temperature T; finally, connecting, by means of wire bonding W, the two sensor terminals 21, 22 to the substrate S, so that the electrical signal V is made available outside the integrated electronic power component 3 and the temperature detection component 2.

According to different implementation options of the method, the method is carried out by means of an electronic device 1 according to any one of the device embodiments described above.

As can be observed, the object of the present invention is fully achieved by the device 1 by virtue of its functional and structural features.

In fact, the device 1 includes a temperature detection component 2 directly attached to a surface portion of the integrated electronic power component 3.

The fact that the temperature detection component 2 has a planar configuration, in the sense illustrated above, allows to guarantee the necessary electrical insulation also in such conditions.

The fact that the temperature detection component is very close to the integrated electronic power component 3 ensures that the temperature sensor is in substantially isothermal conditions with the electronic power component 3. In turn, this allows to considerably increase the achievable accuracy of the estimate of the temperature T3 of the electronic power component 3, as desired. Furthermore, the promptness of detection response, and thus the capacity of detecting temperature peaks, also of very short duration, is considerably improved.

Moreover, it must be observed that the advantages described above are obtained without requiring an integration of the temperature sensor in the same chip as the electronic power component, but instead in a configuration in which the two components are made by means of different chips.

The device according to the invention can thus be advantageously installed in battery-load systems in electrical or hybrid vehicles.

Similar advantages can be identified with reference to the modules, systems and methods using the device described above.

A person skilled in art may make changes and adaptations to the embodiments of the device described above, or can replace elements with others which are functionally equivalent, to satisfy contingent needs without departing from the scope of protection of the appended claims. All the features described as belonging to one possible embodiment may be implemented independently from the other embodiments described. The figures are not in scale because they privilege the requirement of appropriately highlighting the various parts for the sake of better illustration clarity.

## Claims

1. Electronic device (1) adapted to be mounted on a substrate (S), the device (1) comprising a temperature detection component (2) and an integrated electronic power component (3) having a first surface portion (31), adapted to be mounted on the substrate (S), and a second surface portion (32), opposite to the first surface portion (31),
wherein the temperature detection component (2) comprises:
- two sensor terminals (21, 22), adapted to be connected to the substrate (S) by means of wire bonding (W);
- a temperature sensor (20), configured to detect a temperature (T) representative of the temperature (T3) of the integrated electronic power component (3) and to provide, by means of the two sensor terminals (21, 22), an electrical signal (V) representative of the temperature detected (T);
- an electrically insulating support (23), having a gluing surface (24) glued on said second surface portion (32) of the integrated electronic power component (3);
and wherein the temperature sensor (20) and the sensor terminals (21, 22) are arranged in a planar configuration on a surface (25) of the support (23) opposite to the gluing surface (24), so that the temperature detection component (2) is superimposed on the integrated electronic power component (3) and so that the temperature sensor (20) and the two sensor terminals (21, 22) are electrically insulated with respect to the integrated electronic power component (3).

2. Device (1) according to claim 1, wherein:
- the temperature detection component (2) comprises a planar thermistor (2) made by means of a first chip;
- the integrated electronic power component (3) is made by means of a second chip, wherein said second surface portion (32) is an electrically conductive portion;
- the temperature detection component (2) is glued on the integrated electronic power component (3) by means of non-conductive glue (G);
- said first and second chip are arranged on top of each other in a "chip-on-chip" configuration.

3. Device (1) according to claim 1 or 2, wherein the integrated electronic power component (3) comprises at least one active element belonging to the set comprising: power insulated gate bipolar transistor (IGBT) and/or diode and/or power MOS field-effect transistor (MOSFET).

4. Device (1) according to claim 3, comprising a plurality of said active elements, said plurality comprising:
at least one MOSFET transistor;
or at least one power insulated gate bipolar transistor (IGBT) and at least one diode.

5. Device according to any one of claims 1-4, wherein the electrically insulating support (23) comprises a layer of insulating ceramic.

6. Device according to any one of claims 1-4, wherein the electrically insulating support (23) comprises a layer of oxidized silicon.

7. Device (1) according to any one of the preceding claims, wherein the temperature sensor (2) comprises a resistor element (R) having a resistance (R) variable in a known manner depending on the temperature.

8. Device (1) according to any one of the preceding claims, wherein the temperature sensor (2) is made by means of planar thin film technology.

9. Electronic module (10) comprising:
- a ceramic substrate (S);
- at least one device (1) according to any one of claims 1-8, mounted on said substrate (S);
- two electrical terminals (11, 12) for direct current;
- a further electrical terminal (13) for alternating current.

10. Module (10) according to claim 9, configured to be connected by means of the two electrical terminals for direct current (11, 12) at voltages equal to or higher than 380 V, and to operate on electricity flows having power equal to or greater than 50 kW.

11. Module (10) according to claim 9, configured to be connected by means of the two electrical terminals for direct current (11, 12) at voltages comprised between 40 V and 60 V, and to operate on electricity flows having power between 10 kW and 30 kW.

12. System (100) comprising:
- three modules (10) according to any one of claims 9-11;
- control means (15), configured to receive from one or more of the temperature detection components (2) one or more electrical signals (V, V', V") representative of the temperatures detected (T, T', T"), respectively, and further configured to estimate the temperatures (T3, T3', T3") of the integrated electronic power components (3), based on said one or more electrical signals (V, V', V"), and to regulate the operation of the system (100) based on the estimated temperatures (T3, T3', T3");
the system (100) being adapted to manage three-phase voltages/currents.

13. System (100) according to claim 12, wherein the control means (15) comprise a control processor (15), configured to carry out safety procedures, reducing or eliminating the electricity flows at predefined risk conditions associated with exceeding one or more predefined temperature thresholds.

14. Method for measuring an operating temperature of an integrated electronic power component (3) having a first surface portion (31), adapted to be mounted on a substrate (S), and a second surface portion (32), opposite to the first surface portion (31), the method involving the steps of:
- gluing on said second surface portion (32) of the integrated electronic power component (3) a temperature detection component (2), having planar configuration and comprising two sensor terminals (21, 22), a temperature sensor (20) and an electrically insulating support (23), so that the temperature detection component (2) is superimposed on the integrated electronic power component (3) and the temperature sensor (20) and the two sensor terminals (21, 22) are electrically insulated from the integrated electronic power component (3);
- detecting, by means of the temperature sensor (20), a temperature (T) present at the sensor (20) and representative of the temperature (T3) of the integrated electronic power component (3);
- supplying, by means of the two sensor terminals (21, 22), an electrical signal (V) representative of the temperature (T) detected;
- connecting, by means of wire bonding (W), the two sensor terminals (21, 22) to the substrate (S), so that the electrical signal (V) is made available outside the integrated electronic power component (3) and the temperature detection component (2).

15. Method according to claim 14, carried out by means of a device (1) according to any one of claims 1-8.
